# EUROPEAN PATENT SPECIFICATION

(11) **EP 3 085 747 B1**
(45) Date of publication and mention of the grant of the patent: **26.06.2019**
(21) Application number: 14872669.8
(22) Date of filing: 05.12.2014
(51) Int. Cl.: C09D 133/04, C09D 183/02, C09D 127/12, H01L 31/042, C08J 7/04, H01L 31/0216

(54) **SOLAR CELL FLUORINATED COATING COMPOSITION, FLUORINATED MULTILAYER FILM, AND SOLAR CELL COMPRISING SAME**
FLUORIERTE BESCHICHTUNGSZUSAMMENSETZUNG FÜR SOLARZELLEN, FLUORIERTE MEHRSCHICHTFOLIE UND SOLARZELLE DAMIT
COMPOSITION DE REVÊTEMENT FLUORÉ POUR CELLULE SOLAIRE, FILM MULTICOUCHE FLUORÉ ET CELLULE SOLAIRE LE COMPRENANT

(30) Priority: 17.12.2013 KR 20130157100; 17.12.2013 KR 20130157120
(43) Date of publication of application: 26.10.2016
(73) Proprietor: Korea Research Institute of Chemical Technology, Daejeon 305-343 (KR)
(72) Inventor: HA, Jong-Wook, Daejeon 302-831 (KR); LEE, Soo Bok, Daejeon 305-756 (KR); PARK, In Joon, Daejeon 305-804 (KR); SOHN, Eun-Ho, Daejeon 305-804 (KR); LEE, Kwang Won, Daejeon 306-830 (KR); YOOK, Shin Hong, Daejeon 305-707 (KR)
(74) Representative: Adam, Holger
(86) International application number: PCT/KR2014/011905
(87) International publication number: WO 2015/093763

(56) References cited:
- EP-A1- 1 956 657
- WO-A1-2012/141402
- JP-A- 2012 251 162
- KR-A- 20130 044 177
- KR-A- 20130 095 943
- KR-A- 20130 121 349
- KR-B1- 101 373 580
- TW-A- 201 347 204
- US-A1- 2013 309 505

## Description

### [Technical Field]

The present invention relates to a fluorine-based multilayer film, and a solar cell including the same, and more particularly, to a fluorine-based multilayer film, and a solar cell including the same, by forming a primer layer with a fluorine-based coating composition including a fluorine-based polymer and a polymer binder, and forming a weather resistant coating layer including a fluorine-based polymer to obtain a fluorine-based multilayer film having a double layer structure composed of the primer layer and the weather resistant coating layer, having excellent adhesion with a substrate film, and improved weather resistance and visible light reflectance.

### [Background Art]

Generally, a solar cell module is a semiconductor element converting light energy to electric energy using a photoelectric effect, and has been recently in the spotlight for the reason of pollution-free, noise-free, and infinite supply of energy.

Particularly, in order to prevent global warming, the Kyoto protocol regulating emission of greenhouse gas such as carbon dioxide and methane gas entered into force on February 16, 2005. In the Republic of Korea where 80% of energy source are import-dependent, new and renewable energy has received attention as an alternative overcoming the fundamental problems of fossil fuels. Among them, solar energy has been established as one of the important alternative energy sources.

A technique to convert solar energy to electric energy using a mediator which is a solar cell module has no mechanical and chemical action in the course of converting solar energy to electric energy, and thus, has benefits of having a simple system structure so that maintenance thereof is rarely required, having a long life, and being safe and environmentally friendly.

This solar cell module is generally manufactured by sequentially stacking tempered glass, an upper EVA (ethylene vinyl acetate) film, a solar battery cell, an EVA film, and a back sheet, and subjecting the stacked module to high temperature compression lamination in a vacuum.

Here, the back sheet serves as waterproofs, insulation, and ultraviolet light protection of the solar battery cell on the rearmost surface of the module, and at the same time, is composed of materials having excellent durability so that it may withstand well even high temperature and humidity, in order to prolong the life of the solar cell module.

Generally, as the sheet used in packaging of the solar cell, a back sheet having excellent weather resistance and durability should be used, so that the solar cell may be stably protected even in a state being exposed to external environment for 20 years or more.

To this end, conventionally the back sheet was mainly used by stacking a fluorine resin film such as PVF (polyvinyl fluoride) or PVDF (polyvinyl difluoride), or applying a fluorine resin composition on one or both surfaces of a substrate film.

However, the fluorine resin films used in the conventional back sheets generally have limitation in use, since they are expensive, and the purchasing conditions thereof are limited. That is, most of the conventional back sheets are currently import-dependent, and thus, are problematic in that they are quite expensive and have low supply.

In addition, since adhesion between a fluorine resin and a substrate film is poor, the adhesion may be improved by stacking the film by applying heat and pressure, or by treating the surface of the substrate film with corona discharge or a similar technique. This method is problematic in that this costs a lot of money for manufacturing the back sheet, and needs capital-intensive equipment.

Korean Patent Laid-Open Publication No. 10-2012-0086081 (Patent Document 1) discloses a single-layer PVdF stretched film for a solar cell back sheet including a polyvinylidene fluoride homopolymer or copolymer, a polymethyl methacrylate homopolymer or copolymer, and titanium oxide.

However, the single-layer PVdF stretched film includes a significant amount of non-fluorine-based binder, and thus, in the case of being exposed to ultraviolet light over a long time of 20 years or more, still has problems of rapidly reduced chemical resistance and weather resistance due to deterioration of the binder by ultraviolet light, and of causing yellowing to reduce the output of the solar cell module.

Patent Document 2 relates to a solar cell module comprising a back sheet and a sealant layer that seals the solar cell in its interior.

Patent Document 3 provides a laminate film for a solar cell protective cover securing transparency as a solar light-receiving layer, and having durability and weather resistance.

Patent Document 4 discloses inter alia a multilayer film formed by coating a cured resin composition material, which includes a fluorinated polymer, an acrylic polymer containing a thermosetting functional group, and a thermal curing agent, onto a base material, the coating layer containing the fluorinated polymer may have superior durability and weather-proofing properties, and further high interface adhesion with the base material may be obtained.

Patent Document 5 discloses a back sheet for a photovoltaic cell comprising a multilayer film. Said multilayer film comprising a substrate, a fluoropolymer coating layer and a primer layer having compatibility with a fluoropolymer.

Patent Document 6 relates to multilayer coating films used in the back sheet of solar cells in order to provide weather resistance. The films comprise a substrate, a urethane acrylate layer and a layer comprising vinylidene fluoride.

### [Related Art Document]

(Patent Document 1) Korean Patent Laid-Open Publication No. 10-2012-0086081 (August 2, 2012)
(Patent Document 2) TW 201347204 A
(Patent Document 3) EP 1 956 657 A1
(Patent Document 4) WO 2012/141402 A1
(Patent Document 5) KR 2013 0044177 A
(Patent Document 6) KR 2013 0121349 A

### [Disclosure]

### [Technical Problem]

An object of the present invention is to provide a fluorine-based multilayer film having excellent adhesion with a substrate film and chemical resistance, by applying a fluorine-based coating composition on one or both surfaces of the substrate film to form a primer layer, and sequentially forming a weather resistant coating layer including a fluorine-based polymer on the primer layer.

Further, another object of the present invention is to provide a fluorine-based multilayer film, which does not include a non-fluorine-based polymer binder in a weather resistant coating layer, thereby maximizing a fluorine atom concentration on the surface, and fundamentally preventing reduced weather resistance due to the deterioration of a binder by ultraviolet light, and the like, and thus, significantly improving weather resistance.

Further, still another object of the present invention is to provide a solar cell including a fluorine-based multilayer film having excellent adhesive property with a substrate film, weather resistance, chemical resistance and visible light reflectance.

### [Technical Solution]

The fluorine-based coating composition used in providing the fluorine-based multilayer film of the present invention includes a fluorine-based polymer; a polymer binder being a polymer of a mixture of a functional monomer including a hydroxyl group-containing acryl-based monomer, and a (meth)acryl-based compound; and an organic solvent.

The fluorine-based polymer may be one or two or more selected from the group consisting of a vinyl fluoride homopolymer, a vinyl fluoride copolymer, a vinylidene fluoride homopolymer, and a vinylidene fluoride copolymer.

The fluorine-based coating composition may include the fluorine-based polymer and the polymer binder at a weight ratio of 90:10 to 10:90, and the solid content of the fluorine-based polymer and the polymer binder may be 10 to 40 wt%.

The fluorine-based polymer may have a weight average molecular weight of 100,000 to 700,000 g/mol, and the polymer binder may have a weight average molecular weight of 10,000 to 300,000 g/mol.

The hydroxyl group-containing acryl-based monomer may be one or two or more selected from the group consisting of 2-hydroxyethyl acrylate, hydroxypropyl acrylate, 2-hydroxyethyl methacrylate, hydroxypropyl methacrylate, and a mixture thereof or a reactant of a monomer thereof with butyrolactone or caprolactone.

The organic solvent may be one or two or more selected from the group consisting of dimethyl formamide (DMF), dimethyl acetamide, dimethyl sulfoxide, N-methyl pyrrolidone, isophorone, methyl ethyl ketone (MEK), acetone, tetrahydrofuran, methyl isobutyl ketone, butyl acetate, cyclohexanone, diacetone alcohol, diisobutyl ketone, ethyl acetoacetate, butyrolactone, propylene carbonate, glyceryl triacetate, and dimethyl phthalate.

In a general aspect of the present invention, a fluorine-based multilayer film comprises a substrate film; a primer layer formed on one or both surfaces on the substrate film; and a weather resistant coating layer formed on the primer layer, wherein the weather resistant coating layer includes a fluorine-based polymer and a white pigment, the primer layer includes the fluorine-based polymer, and a cured product of a polymer binder and an isocyanate-based compound, the fluorine-based polymer is any one or more selected from the group consisting of a vinyl fluoride homopolymer, a vinyl fluoride copolymer, a vinylidene fluoride homopolymer, and a vinylidene fluoride copolymer, and the polymer binder is a copolymer of a hydroxyl group-containing acryl-based monomer and a (meth)acrylate-based compound, the hydroxyl group-containing acryl-based monomer being any one or more selected from the group consisting of any one or more monomer selected from 2-hydroxyethyl acrylate, hydroxypropyl acrylate, 2-hydroxyethyl methacrylate and hydroxypropyl methacrylate, or a reactant of the monomer with butyrolactone or caprolactone.

According to an exemplary embodiment of the present invention, the weather resistant coating layer may further include 1 to 50 parts by weight of the white pigment based on 100 parts by weight of the fluorine-based polymer, and the fluorine-based polymer may be one or two or more selected from the group consisting of a vinyl fluoride homopolymer, a vinyl fluoride copolymer, a vinylidene fluoride homopolymer, and a vinylidene fluoride copolymer.

According to an exemplary embodiment of the present invention, a surface of the weather resistant coating layer may have a fluorine atom concentration of 40 atom% or more, and an oxygen atom concentration less than 5 atom%, measured by X-ray photon spectroscopy.

According to an exemplary embodiment of the present invention, adhesion between the substrate film and the weather resistant coating layer may be 0.1 to 1.0 N/mm, and reflectance in a visible light region may be 60 to 98%, wherein the adhesion is measured according to ASTM D1876, using a universal material testing machine to perform T-peel test at a load of 10 kgf, and a crosshead speed of 100 mm/min, and wherein reflectance is measured by using a UV/VIS spectroscope equipped with an integrating sphere to measure average reflectance in a visible light region (350-800 nm).

According to an exemplary embodiment of the present invention, the fluorine-based multilayer film may be included in a solar cell back sheet.

In still another general aspect, a solar cell includes the fluorine-based multilayer film as described above.

According to an exemplary embodiment of the present invention, the fluorine-based multilayer film may further include a cell adhesive layer.

### [Advantageous Effects]

The fluorine-based coating composition for a solar cell used in the present invention may significantly improve adhesion with a substrate film, and improve chemical resistance and weather resistance, by including a fluorine-based polymer and a polymer binder.

The fluorine-based multilayer film may significantly improve adhesion with a substrate film by forming a primer layer using the fluorine-based coating composition for a solar cell on one or both surfaces of the substrate film, and may significantly improve not only chemical resistance but also a visible light reflectance property by increasing a fluorine atom concentration on a surface of a weather resistant coating layer formed on the primer layer.

Further, since the fluorine-based multilayer film does not include a non-fluorine-based polymer binder such as an acryl-based resin on a weather resistant coating layer, it may fundamentally block deterioration of a coating layer even in the case of being exposed to ultraviolet light over a long time, and significantly improve weather resistance, and thus, is suitable as a back sheet for a solar cell.

### [Description of Drawings]

FIG. 1 is a cross-sectional view of a one sided fluorine-based multilayer film according to an exemplary embodiment of the present invention.
FIG. 2 is a cross-sectional view of a both sided fluorine-based multilayer film according to an exemplary embodiment of the present invention.
FIG. 3 is a cross-sectional view of a fluorine-based multilayer film including a cell adhesive layer according to an exemplary embodiment of the present invention.

### [Best Mode]

Hereinafter, the fluorine-based multilayer film, and the solar cell including the same of the present invention will be described in detail. The exemplary embodiments of the present invention described below are provided by way of example so that the idea of the present invention can be sufficiently transferred to a person skilled in the art. In addition, technical terms and scientific terms used in the present specification have the general meaning understood by a person skilled in the art unless otherwise defined, and a description for the known function and configuration obscuring the present invention will be omitted in the following description.

As a result of research for developing a fluorine-based multilayer film for a solar cell having excellent adhesion with a substrate film and weather resistance, the inventors of the present invention found out that excellent adhesion with a substrate film, and significantly improved weather resistance, chemical resistance and visible light reflectance property may be obtained without forming another adhesive layer on the substrate film, or surface treatment such as corona discharge, by forming a primer layer including a fluorine-based polymer and a polymer binder on a substrate film, and forming a weather resistant coating layer including a fluorine-based polymer on the primer layer, thereby manufacturing a fluorine-based multilayer film having a double layer structure, and have completed the present invention.

Hereinafter, each component will be described in more detail.

### (A) Fluorine-based polymer

The fluorine-based polymer according to an exemplary embodiment of the present invention serves to improve adhesion with a substrate film together with a polymer binder, and prevents degraded performance of a substrate film by external environment, thereby complementing the durability and weather resistance of a fluorine-based multilayer film. As the fluorine-based polymer, it is used one or two or more selected from the group consisting of a vinyl fluoride homopolymer, a vinyl fluoride copolymer, a vinylidene fluoride homopolymer, and a vinylidene fluoride copolymer.

A fluorine-based monomer forming the vinyl fluoride copolymer or vinylidene fluoride copolymer may be selected from the group consisting of fluoroolefin, fluorovinyl ether, and fluorodioxole, but not limited thereto. More particularly, one or two or more selected from the group consisting of tetrafluoroethylene (TFE), hexafluoropropylene (TFP), chlorotrifluoroethylene (CTFE), trifluoroethylene, hexafluoroisobutylene, perfluorobutylethylene, perfluoropropylvinyl ether (PPVE), perfluoroethylvinyl ether (PEVE), perfluoromethylvinyl ether (PMVE), perfluoro-2,2-dimethy-1,3-dioxole (PDD), and perfluoro-2-methylene-4-methyl-1,3-dioxolane (PMD) may be used.

When the vinylidene fluoride homopolymer, vinylidene fluoride copolymer or mixture thereof is used as the fluorine-based polymer, it is preferred to include 60 to 90 mol%, more preferably, 80 to 90 mol% of the vinylidene fluoride, based on a total number of moles of the fluorine-based polymer. If less than 60 mol% of the vinylidene fluoride is included, based on the total number of moles of the fluorine-based polymer, the effects of durability, weather resistance and low-temperature drying property required for the fluorine-based multilayer film may become negligible.

Further, when a mixture of vinylidene fluoride and other fluorine-based monomer is used as the fluorine-based polymer, if the content of other fluorine-based monomer is higher than that of vinylidene fluoride, based on the total number of moles of the fluorine-based polymer, the fluorine-based coating composition may have reduced stability, and it will be difficult to form a uniform primer layer.

The fluorine-based polymer according to an exemplary embodiment of the present invention may have a weight average molecular weight of preferably 100,000 to 700,000 g/mol, more preferably 150,000 to 500,000 g/mol. If the fluorine-based polymer has a weight average molecular weight less than 100,000 g/mol, the primer layer may have reduced durability, and if more than 700,000 g/mol, the fluorine-based polymer may contain a large amount of branched chain in the chemical structure, which increases the fraction of the gel being insoluble in a solvent so that the coating becomes uneasy, and thus, the stability of the fluorine-based coating composition is reduced, and it may be difficult to form the uniform primer layer.

### (B) Polymer binder

The polymer binder according to an exemplary embodiment of the present invention is a polymer of a mixture of a functional monomer and a (meth)acryl-based compound. The polymer binder may improve adhesion with a substrate film together with the fluorine-based polymer, and improve the stability of the fluorine-based coating composition, thereby serving to improve the durability of the fluorine-based multilayer film.

The functional monomer is a hydroxyl group-containing acryl-based monomer.

The polymer binder according to an exemplary embodiment of the present invention may be prepared by polymerizing the hydroxyl group-containing acryl-based monomer with the (meth)acrylate-based compound. The polymerization method is not limited as long as it is clearly known in the art, and bulk polymerization, suspension polymerization, and emulsion polymerization may be used.

By way of example, 1 to 40 wt% of the functional monomer and 60 to 99 wt% of the (meth)acrylate compound may be polymerized to prepare the polymer binder.

The (meth)acrylate-based compound may be one or two or more selected from the group consisting of methyl acrylate, ethyl acrylate, n-butyl acrylate, iso-butyl acrylate, octadecylmethacrylate, lauryl methacrylate, dimethylaminoethyl methacrylate, tertiarybutylaminoethyl methacrylate, diethylaminoethyl methacrylate, glycidyl acrylate, glycidyl methacrylate, 2-ethylhexyl acrylate, 2-ethylhexyl methacrylate, 2-isocyanoethyl acrylate, and 2-isocyanoethyl methacrylate, but not limited thereto.

By way of another example, in the case that a hydroxyl group-containing acryl-based monomer is used as the functional monomer when preparing the polymer binder, a molecular weight regulator may be further included to carry out emulsion polymerization.

The hydroxyl group-containing acryl-based monomer may include, for example, 2-hydroxyethyl acrylate (HEA), hydroxypropyl acrylate (HPA), 2-hydroxyethyl methacrylate (HEMA), hydroxypropyl methacrylate (HPMA), and a mixture thereof or a reactant of a monomer thereof with butyrolactone or caprolactone.

For regulating the molecular weight of the polymer binder according to an exemplary embodiment of the present invention, the molecular weight regulator may be further included. This may prevent production of a high molecular weight binder being insoluble in a water solvent, which is resulted in the impurities contained in the hydroxyl group-containing acryl-based monomer, and when forming a primer layer later, this is effective for improving adhesion with the substrate film and weather resistant coating layer.

The molecular weight regulator is not limited as long as it is generally used in the art, but preferably, it may be alkane thiol. By way of example, it may be one or two or more selected from the group consisting of propane thiol, butane thiol, pentane thiol, hexane thiol, heptane thiol, octane thiol, nonane thiol, decane thiol, and undecane thiol, and more preferably, it may be octane thiol.

Further, the content of the molecular weight regulator may not be limited in a range of not hindering the physical properties of the polymer binder, and more preferably, the content may be 1 to 2 wt%, based on the content of the (meth)acrylate-based compound and hydroxyl group-containing acryl-based monomer.

Further, it is preferred that the polymer binder prepared with the acryl-based monomer containing a hydroxyl group has an OH value of 0.01 to 2 mg KOH/g, more preferably, 0.1 to 1 mg KOH/g. If the polymer binder has an OH value less than 0.01 mg KOH/g, the crosslinking effect by a crosslinking agent hardly appears so that the primer layer has reduced durability, and the adhesion with a substrate may not be expected, and if the polymer binder has an OH value more than 2 mg KOH/g, the compatibility of the polymer binder with the fluorine-based polymer is reduced to cause phase separation after coating, and thus, a uniform primer layer may not be formed, and also durability is reduced. Further, if the amount of the hydroxyl group is too large, the crosslinking degree is increased more than necessary, so that the physical properties of coating may be lowered, and thus, the amount of the hydroxyl group being within the above described range is effective, since a uniform and durable primer layer may be formed with the fluorine-based polymer and curing agent.

The polymer binder according to an exemplary embodiment of the present invention may have a weight average molecular weight of 10,000 to 300,000 g/mol, more preferably 20,000 to 100,000 g/mol.

If the polymer binder has a weight average molecular weight less than 10,000 g/mol, the primer layer will have reduced durability, and also the coating solution will have unduly low viscosity so that the stability of the fluorine-based coating composition is reduced, thereby making it difficult to form uniform coating; and if more than 300,000 g/mol, the composition will have too high viscosity, so that it is difficult to form a uniform primer layer.

It is preferred that the fluorine-based coating composition includes the fluorine-based polymer and the polymer binder at a weight ratio of 90:10 to 10:90, more preferably at a weight ratio of 20:80 to 50:50.

If the fluorine-based polymer is included at a weight ratio less than 20, or the polymer binder is included at a weight ratio more than 90, durability may be reduced when exposed to the outdoor over a long time, and if the fluorine-based polymer is included at a weight ratio more than 80, or the polymer binder is included at a weight ratio less than 20, the adhesion between a substrate film and a weather resistant coating layer becomes weak, so that the weather resistant coating layer may be peeled off. Further, the expensive fluorine-based polymer being included more than necessary may be uneconomical.

### (C) Organic solvent

The organic solvent is added in order to improve compatibility of the fluorine-based polymer and the polymer binder in the fluorine-based coating composition, and form a uniform coating layer, and a ketone-based solvent or a carbonate-based solvent having a high boiling point may be mainly used, but not limited thereto.

More particularly, one or two or more selected from the group consisting of dimethyl formamide (DMF), dimethyl acetamide, dimethyl sulfoxide, N-methyl pyrrolidone, isophorone, methyl ethyl ketone (MEK), acetone, tetrahydrofuran, methyl isobutyl ketone, butyl acetate, cyclohexanone, diacetone alcohol, diisobutyl ketone, ethyl acetoacetate, butyrolactone, propylene carbonate, glyceryl triacetate, and dimethyl phthalate are effective for dispersion.

The organic solvent may be included at 60 to 90 wt%, more preferably 75 to 85 wt%, based on the total fluorine-based coating composition. That is, the solid content of the fluorine-based polymer and the polymer binder may be 10 to 40 wt%, more preferably 15 to 25 wt%. If the content of the organic solvent is less than 60 wt%, the fluorine-based coating composition may have unduly high viscosity so that it is difficult to form a uniform primer layer, and if more than 90 wt%, the primer layer may be formed to be unduly thin so that durability and chemical resistance are reduced.

The fluorine-based coating composition for a solar cell according to an exemplary embodiment of the present invention may further include a curing agent. The curing agent cures the polymer binder prepared with the fluorine-based polymer and the polymer binder, particularly the polymer binder prepared with the hydroxyl group-containing acryl-based monomer, thereby forming a polyurethane three dimensional network structure, and thus, serves to improve the durability of the primer layer and the adhesion with the substrate film. The curing agent is an isocyanate-based compound which is effective for durability improvement.

The curing agent of the present invention may be one or two or more selected from the group consisting of 2,4-trylene diisocyanate, 2,6-trylene diisocyanate, hydrogenated trylene diisocyanate, 1,3-xylene diisocyanate, 1,4-xylene diisocyanate, diphenyl methane-4,4-diisocyanate, 1,3-bisisocyanatemethyl cyclohexane, tetramethyl xylene diisocyanate, 1,5-naphthalene diisocyanate, 2,2,4-trimethyl hexamethylene diisocyanate, a trylene diisocyanate adduct of trimethylpropane, a xylene diisocyanate adduct of trimethylolpropane, triphenylmethanetriisocyanate, and methylene bistriisocyanate, but not limited thereto.

As to the content of the curing agent, it is preferred that the ratio of the isocyanate group relative to the hydroxyl group included in the polymer binder (OH:NCO) is in a range of 1:0.1 - 1:10, more preferably in a range of 1:0.5 - 1:5. If the ratio of the hydroxyl group of the polymer binder and the isocyanate group of the curing agent is less than 1:0.1, the crosslinking between the binders or between the binder and the substrate does not occur, and thus, sufficient adhesion and durability may not be expected, and if the ratio of the hydroxyl group of the polymer binder and the isocyanate group of the curing agent is more than 1:10, overcuring occurs to reduce the adhesion between the substrate film and the weather resistant coating layer, and thus, the physical properties of the coating may become vulnerable.

The fluorine-based multilayer film according to another exemplary embodiment of the present invention includes a substrate film; a primer layer formed by the fluorine-based coating composition; and a weather resistant coating layer.

Hereinafter, each component will be described in more detail.

### (C) Substrate film layer

The substrate film layer according to an exemplary embodiment of the present invention serves as a base film of a fluorine-based multilayer film, and a polyester-based resin having excellent durability and moisture resistance may be used. For example, it may be polyethylene terephthalate (PET), polyethylene naphthalate (PEN), or a mixture thereof, but not limited thereto. It may be properly selected according to the function or use of the fluorine-based multilayer film to be prepared.

### (D) Primer layer

The primer layer according to an exemplary embodiment of the present invention is formed by applying the above-described fluorine-based coating composition for a solar cell on one or both surfaces of the substrate film layer, and may improve the adhesion between the weather resistant coating layer and the substrate film layer, and durability.

### (E) Weather resistant coating layer

The weather resistant coating layer according to an exemplary embodiment of the present invention is formed by applying the composition including the fluorine-based polymer on the primer layer, and does not include a polymer other than the fluorine-based polymer, thereby increasing a fluorine atom concentration on the surface, and significantly improving weather resistance.

The weather resistant coating layer of the present invention further includes a white pigment in the composition including the fluorine-based polymer according to the use and purpose.

The fluorine-based polymer which serves to prevent degraded performance of a substrate due to an external environment, thereby complementing the durability and weather resistance of the fluorine-based multilayer film, may be any fluorine-based polymer without limitation as long as it is clearly known in the art, and may be identical or not identical to the fluorine-based polymer included in the fluorine-based coating composition.

More particularly, the fluorine-based polymer forming the weather resistant coating layer is one or two or more selected from the group consisting of a vinyl fluoride homopolymer, a vinyl fluoride copolymer, a vinylidene fluoride homopolymer, and a vinylidene fluoride copolymer.

The fluorine-based monomer forming the vinyl fluoride copolymer and vinylidene fluoride copolymer may be selected from the group consisting of fluoroolefin, fluorovinyl ether, and fluorodioxole. More particularly, one or two or more selected from the group consisting of tetrafluoroethylene (TFE), hexafluoropropylene (TFP), chlorotrifluoroethylene (CTFE), trifluoroethylene, hexafluoroisobutylene, perfluorobutylethylene, perfluoropropylvinyl ether (PPVE), perfluoroethylvinyl ether (PEVE), perfluoromethylvinyl ether (PMVE), perfluoro-2,2-dimethy-1,3-dioxole (PDD), and perfluoro-2-methylene-4-methyl-1,3-dioxolane (PMD) may be used.

When the vinylidene fluoride homopolymer, vinylidene fluoride copolymer or a mixture thereof is used as the fluorine-based polymer, it is preferred to include 70 to 99 mol%, and more preferably, 80 to 90 mol% of the vinylidene fluoride, based on a total number of moles of the fluorine-based polymer. If less than 70 mol% of the vinylidene fluoride is included, based on the total number of moles of the fluorine-based polymer, the effect of durability, weather resistance and low-temperature drying property required for the fluorine-based multilayer film may become negligible.

Further, when a mixture of vinylidene fluoride and other fluorine-based monomer is used as the fluorine-based polymer, if the content of other fluorine-based monomer is higher than that of vinylidene fluoride, based on the total number of moles of the fluorine-based polymer, it will be difficult to form a uniform weather resistant coating layer. Further, it may be easily deteriorated by ultraviolet light when exposed to the outdoor over a long time, thereby reducing durability.

The fluorine-based polymer according to an exemplary embodiment of the present invention may have a weight average molecular weight of preferably 100,000 to 700,000 g/mol, and more preferably 150,000 to 500,000 g/mol.

If the fluorine-based polymer has a weight average molecular weight less than 100,000 g/mol, the primer layer may have reduced durability, and if more than 700,000 g/mol, the fluorine-based polymer may contain a large amount of branched chain in the chemical structure, which increases the fraction of the gel being insoluble in a solvent, so that the coating becomes uneasy, and particularly, in the case of including inorganic particles, the dispersion stability of particles is seriously lowered, so that it is difficult to form a uniform weather resistant coating layer.

The white pigment of the present invention may be further added for the purpose of improving the reflectance of the fluorine-based multilayer film. The white pigment of the present invention is not limited as long as it is clearly known in the art, and may be one or more selected from the group consisting of titanium oxide, silica, alumina and calcium carbonate, and preferably may be titanium oxide.

The content of the white pigment may be 1 to 50 parts by weight, based on 100 parts by weight of the fluorine-based polymer forming the weather resistant coating layer. If the content of the white pigment is less than 1 part by weight, there is concern for the reflectance improvement of the fluorine-based multilayer film becoming insignificant, and if more than 50 parts by weight, processability may be lowered, and the mechanical physical properties such as impact strength may be decreased.

The composition including the fluorine-based polymer of the present invention may further include an organic solvent. The organic solvent is added in order to improve the compatibility of the fluorine-based polymer and the white pigment in the composition including the fluorine-based polymer, and form the uniform weather resistant coating layer on the primer layer, and may be identical or not identical to the organic solvent used in the fluorine-based coating composition.

For example, a ketone-based solvent or carbonate-based solvent having a high boiling point may be mainly used, but not limited thereto, and more particularly, one or two or more selected from the group consisting of dimethyl formamide (DMF), dimethyl acetamide, dimethyl sulfoxide, N-methyl pyrrolidone, isophorone, methyl ethyl ketone (MEK), acetone, tetrahydrofuran, methyl isobutyl ketone, butyl acetate, cyclohexanone, diacetone alcohol, diisobutyl ketone, ethyl acetoacetate, butyrolactone, propylene carbonate, glyceryl triacetate, and dimethyl phthalate are effective.

The method of manufacturing the fluorine-based multilayer film according to an exemplary embodiment of the present invention may include:
preparing a fluorine-based coating composition including a fluorine-based polymer, a polymer binder and an organic solvent;
applying the fluorine-based coating composition on one or both surfaces of a substrate film, which is then subjected to curing to form a primer layer;
preparing a second composition including a fluorine-based polymer, a white pigment and an organic solvent; and
applying the second composition on the primer layer, which is then subjected to curing to form a weather resistant coating layer.

The fluorine-based coating composition and the second composition may be prepared using a common mixing method. The mixing method may be applied without limitation within a range of not changing the physical and chemical properties of the fluorine-based coating composition and the second composition.

Further, the fluorine-based coating composition and the second composition may be provided in the form of a solution or dispersion depending on the kind of a fluorine-based polymer, a non-fluorine-based binder, and an organic solvent, respectively.

The fluorine-based coating composition and second composition may have a viscosity adjusted according to working properties, and the viscosity may be freely changed according to the components, process equipment, and process conditions of each of the fluorine-based coating composition and the second composition.

As a method of applying the fluorine-based coating composition and second composition, knife coating, roll coating, casting coating, spraying coating, calendar coating, dip coating, airknife coating, gravure coating, reverse roll coating and the like may be listed, but not limited thereto.

The fluorine-based coating composition may be applied on one or both surfaces of the substrate film, and cured at 70 to 150 °C for 3 to 30 minutes to form the primer layer.

Further, the second composition may be applied on the primer layer, and cured at 120 to 180 °C for 3 to 30 minutes to form the weather resistant coating layer.

Before curing the primer layer and weather resistant coating layer, a drying step may be further included in order to evaporate the organic solvent contained in the fluorine-based coating composition and second composition, respectively. It is preferred to carry out drying at a lower temperature than curing temperature, and since the predetermined drying step allows the primer layer and weather resistant coating layer to be formed more firmly, it is effective to carry out drying.

The fluorine-based multilayer film according to the present invention, prepared as described above may have a fluorine atom concentration of 40 atom% or more, and an oxygen atom concentration less than 5 atom%, on the surface of the weather resistant coating layer. As the fluorine atom concentration on the surface of the weather resistant coating layer is increased, deterioration/aging by ultraviolet light occurring when exposed to the outdoor over a long time is prevented, thereby significantly improving the weather resistance.

Further, the fluorine-based multilayer film according to the present invention may have adhesion between the substrate film layer and the weather resistant coating layer of 0.1 to 1.0 N/mm, and reflectance in a visible light region of 60 to 98%.

This fluorine-based multilayer film according to the present invention may improve adhesion with a substrate film, and maximize a fluorine atom concentration on the surface of a weather resistant coating layer, thereby having significantly excellent weather resistance and chemical resistance, and also improve the reflection property of visible light, and thus, it is suitable as a back sheet for a solar cell.

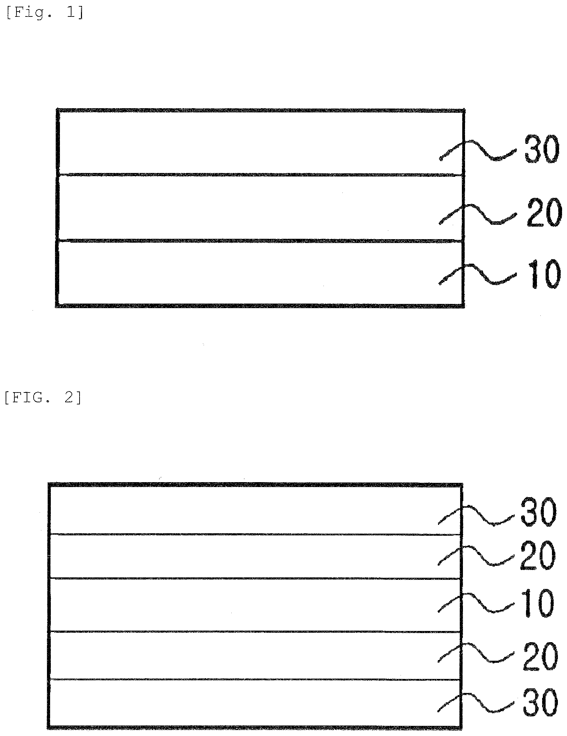

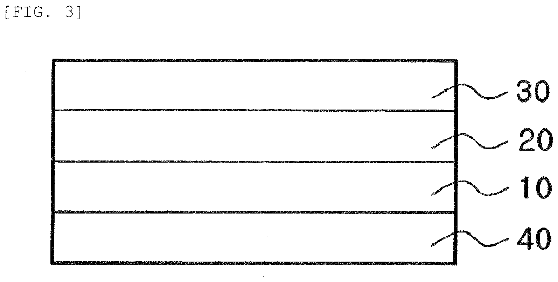

Further, the fluorine-based multilayer film according to the present invention may be formed to be single sided so that a primer layer and a weather resistant coating layer are formed on one surface of a substrate film, as illustrated in FIG. 1, or may be formed to be both sided so that a primer layer and a weather resistant coating layer are formed on both surfaces of a substrate film, as illustrated in FIG. 2. Further, it may be formed to further include a cell adhesive layer, as illustrated in FIG. 3.

Further, according to another exemplary embodiment of the present invention, a solar cell including the fluorine-based multilayer film may be provided.

Hereinafter, the following Examples will be provided in order to describe the present invention in more detail. However, the present invention is not limited to the Examples below.

### Measurement of physical properties

### 1) Adhesive strength

In order to evaluate the adhesion between a substrate film and a primer layer, and the adhesion of a weather resistant coating layer according to ASTM D1876, a universal material testing machine (Instron 4482) was used to perform T-peel test at a load of 10 kgf, and a crosshead speed of 100 mm/min.

### 2) Reflectance measurement

In order to measure the reflectance of the back sheet for a solar cell of the present invention, a UV/VIS spectroscope equipped with an integrating sphere was used to measure average reflectance in a visible light region (350 - 800 nm).

### 3) Fluorine atom and oxygen atom concentrations

The fluorine atom and oxygen atom concentrations of the weather resistant coating layer of the back sheet for a solar cell of the present invention were measured by X-ray photon spectroscopy.

### 4) Weather resistance evaluation

Metaling Vertical Weather Meter MV-3000 (Suga Co., Ltd.) was used to perform promotion weathering evaluation for 300 hours under the following conditions, and the specimens before and after weathering evaluation were compared as determined with naked eyes. When discoloration such as yellowing rarely occurred, it was indicated as "○", when discoloration such as slight yellowing occurred, but in a good level, it was indicated as "Δ", and when discoloration such as significant yellowing and cracks occurred, it was indicated as "x".
- Light Source: Xenon Arc lamp
- Irradiance: 55W/m²
- Temp.: 38 °C
- Black panel temp.: 63 °C
- Relative humidity: 50%

### [Reference Preparation Example 1]

Preparation of polymer binder (1) using alkoxy silane group-containing compound

As shown in the following Table 1, 2.85 g of methyl methacrylate (MMA, Samcheon Chemical, 99%), 0.15 g of 3-methacryloylpropyl trimethoxysilane (SZ-6030, Dow Corning), 0.02 g of 2,2'-azobis(4-methoxy-2,4-dimethyl valeronitrile) (V-70, Wako Pure Chemicals), and 12 g of isophorone (Sigma-Aldrich) were added to a 4-neck reactor, and polymerized at 60 °C for 6 hours, thereby preparing the polymer binder (1).

### [Reference Preparation Examples 2-4]

### Preparation of polymer binder (1) using alkoxy silane group-containing compound

As shown in the following Table 1, the polymer binder (1) was prepared in the same manner as in Reference Preparation Example 1, except that the contents of methyl methacrylate (MMA) and 3-methacryloylpropyl trimethoxysilane were changed.

### [Comparative Preparation Example 1]

### Preparation of polymer binder

As shown in the following Table 1, the polymer binder was prepared in the same manner as in Preparation Example 1, except that 3-methacryloylpropyl trimethoxysilane was not used, and 3.0 g of methyl methacrylate (MMA) was used alone.

**[Table 1]**

| | (Meth)acrylate -based compound | Alkoxysilane-containing compound | Initiator | Organic solvent |
|---|---|---|---|---|
| Ref. Prep. Ex. 1 | 2.85 g | 0.15 g | 0.02 g | 12 g |
| Ref. Prep. Ex. 2 | 2.70 g | 0.30 g | 0.02 g | 12 g |
| Ref. Prep. Ex. 3 | 2.40 g | 0.60 g | 0.02 g | 12 g |
| Ref. Prep. Ex. 4 | 1.80 g | 1.20 g | 0.02 g | 12 g |
| Comp. Prep. Ex. 1 | 3.00 g | - | 0.02 g | 12 g |

### [Reference Example 1]

### Preparation of fluorine-based coating composition

7 g of PVDF (Alfa Aesar) as a fluorine-based polymer, 3 g of the polymer binder of [Ref. Preparation Example 1], and 28 g of isophorone (Sigma-Aldrich) as an organic solvent were mixed to prepare a fluorine-based coating composition having a solid content of 20 wt%.

### Preparation of fluorine-based multilayer film

A polyethylene terephthalate film (Skyrol SG00S, SKC) having a thickness of 250 µm was used as the substrate film. The fluorine-based coating composition was bar-coated to the thickness of 10 µm on one surface of the substrate film heated to 150 °C, and dried for 10 minutes to prepare a fluorine-based multilayer film, and the adhesive strength and weather resistance thereof were measured and listed in the following Table 2.

### [Reference Examples 2-4]

As shown in the following Table 2, the fluorine-based multilayer film was prepared in the same manner as in Ref. Example 1, except that the polymer binders of Ref. Preparation Examples 2-4 were used, respectively, when preparing the fluorine-based coating composition, and the physical properties thereof were measured, and listed in the following Table 2.

### [Reference Examples 5-6]

As shown in the following Table 2, the fluorine-based multilayer film was prepared in the same manner as in Ref. Example 1, except that the contents of the polymer binder and fluorine-based polymer of Ref. Preparation Example 2 were changed when preparing the fluorine-based coating composition, and the physical properties thereof were measured, and listed in the following Table 2.

### [Comparative Example 1]

As shown in the following Table 2, the fluorine-based multilayer film was prepared in the same manner as in Ref. Example 1, except that the alkoxysilyl polymer binder was not used, and the fluorine-based polymer was used alone, when preparing the fluorine-based coating composition, and the physical properties thereof were measured, and listed in the following Table 2.

### [Comparative Example 2]

As shown in the following Table 2, the fluorine-based multilayer film was prepared in the same manner as in Ref. Example 1, except that the polymer binder of Comparative Preparation Example 1 was used, respectively, when preparing the fluorine-based coating composition, and the physical properties thereof were measured, and listed in the following Table 2.

**[Table 2]**

| | Fluorine-based coating layer | | | | Adhesion (N/mm) | Weather resistance evaluation | |
|---|---|---|---|---|---|---|---|
| | Polymer binder | | Fluorine-based polymer | Organic solvent | | | |
| | kind | weight (g) | weight (g) | weight (g) | | 100 hrs | 300 hrs |
| Ref. Ex. 1 | Ref. Prep. Ex. 1 | 3 | 7 | 28 | 0.026 | ○ | ○ |
| Ref. Ex. 2 | Ref. Prep. Ex. 2 | 3 | 7 | 28 | 0.115 | ○ | ○ |
| Ref. Ex. 3 | Ref. Prep. Ex. 3 | 3 | 7 | 28 | 0.383 | ○ | ○ |
| Ref. Ex. 4 | Ref. Prep. Ex. 4 | 3 | 7 | 28 | 0.485 | ○ | ○ |
| Ref. Ex. 5 | Ref. Prep. Ex. 2 | 7 | 3 | 28 | 0.455 | Δ | X |
| Ref. Ex. 6 | Ref. Prep. Ex. 2 | 1 | 9 | 28 | 0.059 | ○ | Δ |
| Comp. Ex. 1 | - | - | 10 | 28 | Peeled off | X | X |
| Comp. Ex. 2 | Comp. Prep. Ex. 1 | 3 | 7 | 28 | 0.002 | x | X |

As shown in the above Table 2, in Comparative Example 1, coating on the substrate film was impossible without using the polymer binder, and even in the case of being coated, the coating layer was peeled off when the solvent was evaporated. In Comparative Example 2, as the compound containing an alkoxysilane group was not included, the adhesion was significantly lowered, and thus, the composition was recognized as being unsuitable as the fluorine-based coating composition.

In addition, it was recognized that as shown in Ref. Examples 2, 5 and 6, as the content of the polymer binder is increased, the adhesion was improved, and in Ref. Example 5, the adhesion was excellent, but the content of the fluorine-based polymer was not sufficient, so that yellowing initially occurred, and weather resistance was decreased. In Ref. Example 6, the initial weather resistance was excellent, but in terms of the weather resistance after 300 hours, the adhesion with the substrate film was not good, and thus, a problem of the coating layer being peeled off occurred.

### [Preparation Example 5]

### Preparation of polymer binder (2) using hydroxyl group-containing acryl-based monomer

As shown in the following Table 3, 0.5 g of sodium dodecyl sulfate (SDS, Acros, 95%) and 0.3 g of sodium bicarbonate (SBC, Sigma-Aldrich, 99%) were dissolved in 190 g of distilled water, and then transferred into 500 ml 4-neck reactor equipped with a condenser and a thermometer, and heated to 80 °C. 10 g of 5 wt% sodium persulfate (SPS, Sigma-Aldrich, 98%) was added thereto, and then a mixture of 47.5 g of methyl methacrylate (MMA, Samcheon Chemical, 99%), 2.5 g of 2-hydroxyethyl methacrylate (HEMA, Sigma-Aldrich, 98%) and 0.5 g of 1-octanethiol (C8SH, TCI, 99%) was added to the reactor at a flow rate of 20 ml/h using a syringe pump. For 3 hours after finishing the addition, emulsion polymerization was carried out to end the synthesis of the copolymer, the dispersion completing the reaction dried, which was then washed with distilled water several times to remove inorganics and a surfactant, and the polymer binder 2 was recovered in a powder form.

### [Preparation Examples 6-8]

### Preparation of polymer binder (2) using hydroxyl group-containing acryl-based monomer

As shown in the following Table 3, the polymer binder was prepared in the same manner as in Preparation Example 5, except that the contents of methyl methacrylate (MMA) and 2-hydroxyethyl methacrylate (HEMA) were changed, and recovered as a powder form.

**[Table 3]**

| | Distilled water | MMA | HEMA | SDS | SBC | C8SH | SPS |
|---|---|---|---|---|---|---|---|
| Prep. Ex. 5 | 200 | 47.5 | 2.5 | 0.5 | 0.3 | 0.5 | 0.5 |
| Prep. Ex. 6 | 200 | 45.0 | 5.0 | 0.5 | 0.3 | 0.5 | 0.5 |
| Prep. Ex. 7 | 200 | 40.0 | 10.0 | 0.5 | 0.3 | 0.5 | 0.5 |
| Prep. Ex. 8 | 200 | 37.5 | 12.5 | 0.5 | 0.3 | 0.5 | 0.5 |

### [Example 7]

### Preparation of fluorine-based coating composition

4g of PVDF (Alfa Aesar) as a fluorine-based polymer, 6g of the polymer binder of [Preparation Example 5], 0.2 g of TDI (Junsei) as the curing agent, and 40g of isophorone (Sigma-Aldrich) as an organic solvent were mixed to prepare a fluorine-based coating composition of a solid content of 20 wt%, exclusive of a curing agent.

### Preparation of second composition

10g of PVDF (Alfa Aesar) as a fluorine-based polymer, 1.5 g of TiO2 (TS-6200, DuPont) as a white pigment, and 40g of isophorone (Sigma-Aldrich) as an organic solvent were mixed to prepare a second composition of a solid content of 20 wt%, exclusive of the white pigment.

### Primer layer formation

A polyethylene terephthalate film (Skyrol SG00S, SKC) having a thickness of 250 µm was used as the substrate film. The fluorine-based coating composition was bar-coated to a thickness of 10 µm on one surface of the substrate film heated to 100 °C, and heated for 10 minutes to form a primer layer.

### Weather resistant coating layer formation

The substrate film having the primer layer formed thereon was heated to a temperature of 150 °C. The second composition was bar-coated to a thickness of 10 µm on the heated primer layer, and heated for 10 minutes to form a weather resistant coating layer.

A back sheet for a solar cell formed by the primer layer and weather resistant coating layer on the substrate film was manufactured in this manner, and the physical properties for evaluation such as adhesion strength, reflectance, fluorine atom concentration, and weather resistance was measured, and listed in Table 5.

### [Reference Examples 8-10]

As shown in the following Table 4, the back sheet for a solar cell formed by the primer layer and weather resistant coating layer on the substrate film was manufactured in the same manner as in Example 7, except that the polymer binders of Reference Preparation Examples 2-4 were used, respectively, when preparing the fluorine-based coating composition, and the physical properties for evaluation such as adhesion strength, reflectance, fluorine atom concentration and weather resistance were measured, and listed in the following Table 5.

### [Reference Examples 11-12]

As shown in the following Table 4, the back sheet for a solar cell formed by the primer layer and weather resistant coating layer on the substrate film was manufactured in the same manner as in Reference Example 8, except that the content of the curing agent was changed, respectively, when preparing the fluorine-based coating composition, and the physical properties for evaluation such as adhesion strength, reflectance, fluorine atom concentration and weather resistance were measured, and listed in the following Table 5.

### [Reference Example 13]

As shown in the following Table 4, the back sheet for a solar cell formed by the primer layer and weather resistant coating layer on the substrate, film was manufactured in the same manner as in Reference Example 8, except that the contents of the polymer binder and curing agent were changed, respectively, when preparing the fluorine-based coating composition, and the physical properties for evaluation such as adhesion strength, reflectance, fluorine atom concentration and weather resistance were measured, and listed in the following Table 5.

### [Comparative Example 3]

As shown in the following Table 4, the back sheet for a solar cell formed by only the weather resistant coating layer on the substrate film was manufactured in the same manner as in Reference Example 8, except that the primer layer was not formed, and the physical properties for evaluation such as adhesion strength, reflectance, fluorine atom concentration and weather resistance were measured, and listed in the following Table 5.

### [Comparative Example 4]

As shown in the following Table 4, the back sheet for a solar cell formed by only the primer layer on the substrate film was manufactured in the same manner as in Reference Example 8, except that the weather resistant coating layer was not formed, and the physical properties for evaluation such as adhesion strength, reflectance, fluorine atom concentration and weather resistance were measured, and listed in the following Table 5.

**[Table 4]**

| | Primer layer | | | | | Weather resistant coating layer | | | | | |
|---|---|---|---|---|---|---|---|---|---|---|---|
| | Polymer binder | | Fluorine -based polymer | Curing agent | Organic solvent | Fluorine -based polymer | White pigment | Organic solvent | Polymer binder | | Curing agent |
| | kind | wt. | wt. | wt. | wt. | wt. | wt. | wt. | kind | wt. | wt. |
| Ex. 7 | Prep. Ex. 5 | 4 g | 6 g | 0.2 g | 40 g | 10 g | 1.5 g | 40 g | - | - | - |
| Ref. Ex. 8 | Prep. Ex. 6 | 4 g | 6 g | 0.4 g | 40 g | 10 g | 1.5 g | 40 g | - | - | - |
| Ref. Ex. 9 | Prep. Ex. 7 | 4 g | 6 g | 0.8 g | 40 g | 10 g | 1.5 g | 40 g | - | - | - |
| Ref. Ex. 10 | Prep. Ex. 8 | 4 g | 6 g | 1.0 g | 40 g | 10 g | 1.5 g | 40 g | - | - | - |
| Ref. Ex. 11 | Prep. Ex. 6 | 4 g | 6 g | 0.6 g | 40 g | 10 g | 1.5 g | 40 g | - | - | - |
| Ref. Ex. 12 | Prep. Ex. 6 | 4 g | 6 g | 0.8 g | 40 g | 10 g | 1.5 g | 40 g | - | - | - |
| Ref. Ex. 13 | Prep. Ex. 6 | 3 g | 7 g | 0.9 g | 40 g | 10 g | 1.5 g | 40 g | - | - | - |
| Comp. Ex. 3 | - | - | - | - | - | 7 g | 1.5 g | 40 g | Prep. Ex. 5 | 7 g | 0.1 g |
| Comp. Ex.4 | Prep. Ex. 6 | 4 g | 6 g | 0.4 g | 40 g | - | - | - | - | - | - |

**[Table 5]**

| | Adhesion (N/mm) | | Surface atom concentration (atom%) | | | Reflec tance (% ) | Weather resistance evaluation | |
|---|---|---|---|---|---|---|---|---|
| | Primer layer | Weather resistant coating layer | C | F | O | | 100 hrs | 300 hrs |
| Ex. 7 | 0.127 | 0.311 | 49.9 | 50.1 | - | 81 | Δ | Δ |
| Ref. Ex. 8 | 0.255 | 0.323 | 48.8 | 51.0 | 0.2 | 83 | ○ | Δ |
| Ref. Ex. 9 | 0.449 | 0.420 | 48.9 | 51.1 | - | 82 | ○ | ○ |
| Ref. Ex. 10 | 0.514 | 0.401 | 49.8 | 50.2 | - | 82 | ○ | ○ |
| Ref. Ex. 11 | 0.338 | 0.417 | 49.5 | 50.5 | - | 78 | ○ | ○ |
| Ref. Ex. 12 | 0.507 | 0.431 | 49.7 | 50.3 | - | 80 | ○ | ○ |
| Ref. Ex. 13 | 0.576 | 0.422 | 49.3 | 50.7 | - | 81 | ○ | ○ |
| Comp. Ex. 3 | - | 0.050 | 29.4 | 45.3 | 25.3 | 83 | X | X |
| Comp. Ex. 4 | 0.255 | - | 51.6 | 33.8 | 15.6 | 9.8 | Δ | X |

As shown in the above Table 5, in Example 7 and Reference Examples 8 to 13, as the weather resistant coating layer including the fluorine-based polymer was formed on the primer layer, not only the adhesion between substrate-primer layer, but also the adhesion between primer layer-weather resistant coating layer is excellent, and the weather resistance is expected to be excellent, with the surface fluorine concentration of 50 atom% or more. Further, since the average reflectance was improved, it is recognized as being suitable as a back sheet for a solar cell.

However, in Comparative Example 3, as the primer layer was not formed, the adhesion of the weather resistant coating layer was significantly decreased, and the weather resistance is expected to be decreased, with the surface fluorine concentration less than 50 atom%. Further, in Comparative Example 4, as the weather resistant coating layer was not formed, and the primer layer was formed alone, the adhesion between the substrate film and the primer layer was not good, the average reflectance was significantly decreased, and the weather resistance was insufficiently implemented, with the surface fluorine concentration less than 50 atom%, and thus, it is recognized as being unsuitable as a back sheet for a solar cell.

### [Detailed Description of Main Elements]

- 10:: Substrate film
- 20:: Primer layer
- 30:: Weather resistant coating layer
- 40:: Cell adhesive layer

## Claims

1. A fluorine-based multilayer film comprising:
a substrate film;
a primer layer formed on one or both surfaces on the substrate film; and
a weather resistant coating layer formed on the primer layer,
wherein the weather resistant coating layer includes a fluorine-based polymer and a white pigment,
the primer layer includes the fluorine-based polymer, and a cured product of a polymer binder and an isocyanate-based compound,
the fluorine-based polymer is any one or more selected from the group consisting of a vinyl fluoride homopolymer, a vinyl fluoride copolymer, a vinylidene fluoride homopolymer, and a vinylidene fluoride copolymer, and
the polymer binder is a copolymer of a hydroxyl group-containing acryl-based monomer and a (meth)acrylate-based compound, the hydroxyl group-containing acryl-based monomer being any one or more selected from the group consisting of any one or more monomer selected from 2-hydroxyethyl acrylate, hydroxypropyl acrylate, 2-hydroxyethyl methacrylate and hydroxypropyl methacrylate, or a reactant of the monomer with butyrolactone or caprolactone.

2. The fluorine-based multilayer film of claim 1, wherein the weather resistant coating layer includes 1 to 50 parts by weight of the white pigment, based on 100 parts by weight of the fluorine-based polymer.

3. The fluorine-based multilayer film of claim 1, wherein a surface of the weather resistant coating layer has a fluorine atom concentration of 40 atom% or more, and an oxygen atom concentration less than 5 atom%, measured by X-ray photon spectroscopy.

4. The fluorine-based multilayer film of claim 1, wherein it has adhesion between the substrate film and the weather resistant coating layer of 0.1 to 1.0 N/mm, and reflectance in a visible light region of 60 to 98%, wherein the adhesion is measured according to ASTM D1876, using a universal material testing machine to perform T-peel test at a load of 10 kgf, and a crosshead speed of 100 mm/min, and wherein reflectance is measured by using a UV/VIS spectroscope equipped with an integrating sphere to measure average reflectance in a visible light region (350-800 nm).

5. The fluorine-based multilayer film of claim 1, wherein it is included in a back sheet for a solar cell.

6. A solar cell comprising the fluorine-based multilayer film of claim 5.

7. The solar cell of claim 6, wherein the fluorine-based multilayer film further includes a cell adhesive layer.

## Patentansprüche

1. Mehrschichtfolie auf Fluorbasis, umfassend:
eine Substratfolie;
eine Primerschicht, gebildet auf einer oder beiden Oberflächen auf der Substratfolie; und
eine witterungsbeständige Beschichtungsschicht, gebildet auf der Primerschicht,
wobei die witterungsbeständige Beschichtungsschicht ein Polymer auf Fluorbasis und ein Weißpigment beinhaltet,
die Primerschicht das Polymer auf Fluorbasis und ein gehärtetes Produkt eines polymeren Binders und einer Verbindung auf Isocyanatbasis beinhaltet,
das Polymer auf Fluorbasis eines oder mehrere ist, ausgewählt aus der Gruppe, bestehend aus einem Vinylfluoridhomopolymeren, einem Vinylfluoridcopolymeren, einem Vinylidenfluoridhomopolymeren und einem Vinylidenfluoridcopolymeren, und
der Polymerbinder ein Copolymer ist eines Hydroxylgruppen-enthaltenden Monomeren auf Acrylbasis und einer Verbindung auf (Meth)acrylatbasis, das Hydroxylgruppen-enthaltende Monomer auf Acrylbasis eines oder mehrere ist, ausgewählt aus der Gruppe, bestehend aus einem oder mehreren Monomer(en), ausgewählt aus 2-Hydroxyethylacrylat, Hydroxypropylacrylat, 2-Hydroxyethylmethacrylat und Hydroxypropylmethacrylat, oder einem Reaktanten des Monomeren mit Butyrolacton oder Caprolacton.

2. Mehrschichtfolie auf Fluorbasis nach Anspruch 1, wobei die wetterbeständige Beschichtungsschicht 1 bis 50 Gewichtsteile des Weißpigments, bezogen auf 100 Gewichtsteile des Polymeren auf Fluorbasis, enthält.

3. Mehrschichtfolie auf Fluorbasis nach Anspruch 1, wobei eine Oberfläche der witterungsbeständigen Beschichtungsschicht eine Fluoratomkonzentration von 40 Atom% oder mehr aufweist, und eine Sauerstoffatomkonzentration von weniger als 5 Atom% aufweist, gemessen mittels Röntgen-Photon-Spektroskopie.

4. Mehrschichtfolie auf Fluorbasis nach Anspruch 1, wobei sie eine Adhäsion zwischen der Substratfolie und der witterungsbeständigen Beschichtungsschicht von 0,1 bis 1,0 N/mm aufweist, und eine Reflexion im sichtbaren Lichtbereich von 60 bis 98% aufweist, wobei die Adhäsion gemessen wird gemäß ASTM D1876, unter Verwendung einer Universalmaterialtestmaschine, um den T-Schältest bei einer Belastung von 10 kgf, und einer Kreuzkopfgeschwindigkeit von 100 mm/min durchzuführen, und wobei die Reflexion gemessen wird unter Verwendung eines UV/VIS-Spektroskops, ausgestattet mit einer Integrationskugel, um die durchschnittliche Reflexion in einem sichtbaren Lichtbereich (350-800 nm) zu messen.

5. Mehrschichtfolie auf Fluorbasis nach Anspruch 1, wobei sie in einer Rückseitenfolie für eine Solarzelle enthalten ist.

6. Solarzelle, umfassend die Mehrschichtfolie auf Fluorbasis nach Anspruch 5.

7. Solarzelle nach Anspruch 6, wobei die Mehrschichtfolie auf Fluorbasis des Weiteren eine Zellklebeschicht enthält.

## Revendications

1. Film multicouche à base de fluor comprenant :
un film de substrat ;
une couche d'apprêt formée sur une ou les deux surfaces du film de substrat ; et
une couche de revêtement résistant aux intempéries formée sur la couche d'apprêt,
dans lequel la couche de revêtement résistant aux intempéries inclut un polymère à base de fluor et un pigment blanc,
la couche d'apprêt inclut le polymère à base de fluor, et un produit durci d'un liant polymère et d'un composé à base d'isocyanate,
le polymère à base de fluor est un quelconque ou plusieurs choisi(s) dans le groupe constitué par un homopolymère de fluorure de vinyle, un copolymère de fluorure de vinyle, un homopolymère de fluorure de vinylidène et un copolymère de fluorure de vinylidène, et
le liant polymère est un copolymère d'un monomère à base d'acryle contenant un groupe hydroxyle et d'un composé à base de (méth)acrylate, le monomère à base d'acryle contenant un groupe hydroxyle étant choisi parmi un quelconque ou plusieurs choisi(s) dans le groupe constitué d'un quelconque ou plusieurs monomères choisi(s) parmi l'acrylate de 2-hydroxyéthyle, l'acrylate d'hydroxypropyle, le méthacrylate de 2-hydroxyéthyle et le méthacrylate d'hydroxypropyle, ou un réactif du monomère avec de la butyrolactone ou de la caprolactone.

2. Film multicouche à base de fluor selon la revendication 1, dans lequel la couche de revêtement résistant aux intempéries inclut 1 à 50 parties en poids du pigment blanc, sur la base de 100 parties en poids du polymère à base de fluor.

3. Film multicouche à base de fluor selon la revendication 1, dans lequel une surface de la couche de revêtement résistant aux intempéries a une concentration en atomes de fluor de 40 % atomique ou plus, et une concentration en atomes d'oxygène inférieure à 5 % atomique, mesurées par spectroscopie photonique aux rayons X.

4. Film multicouche à base de fluor selon la revendication 1, dans lequel il a une adhérence entre le film de substrat et la couche de revêtement résistant aux intempéries de 0,1 à 1,0 N/mm, et une réflectance dans une région de lumière visible de 60 à 98 %, dans lequel l'adhérence est mesurée conformément à la norme ASTM D1876, en utilisant une machine universelle de test de matériaux pour effectuer un test de pelage en T à une charge de 10 kgf, et une vitesse de tête transversale de 100 mm/min, et dans lequel la réflectance est mesurée en utilisant un spectroscope UV/VIS équipé d'une sphère d'intégration pour mesurer une réflectance moyenne dans une région de lumière visible (350 à 800 nm).

5. Film multicouche à base de fluor selon la revendication 1, dans lequel il est inclus dans une feuille arrière de cellule solaire.

6. Cellule solaire comprenant le film multicouche à base de fluor selon la revendication 5.

7. Cellule solaire selon la revendication 6, dans laquelle le film multicouche à base de fluor inclut en outre une couche adhésive de cellule.
